# EUROPÄISCHE PATENTANMELDUNG

(11) **EP 3 147 636 A1**
(43) Veröffentlichungstag der Anmeldung: **29.03.2017**
(21) Anmeldenummer: 15186605.0
(22) Anmeldetag: 24.09.2015
(51) Int. Cl.: G01H 3/00, G05D 1/00

(54) **VERFAHREN ZUR MESSUNG DES SCHALLDRUCKPEGELS EINER HOCHSPANNUNGSDROSSEL ODER EINES HOCHSPANNUNGSTRANSFORMATORS**

(71) Anmelder: Siemens Aktiengesellschaft, 80333 München (DE)
(72) Erfinder: Griebler, Peter, 4483 Hargelsberg (AT); Reisinger, Helmut, 4311 Schwertberg (AT)
(74) Vertreter: Maier, Daniel Oliver

(57) **Zusammenfassung**

Verfahren zur Messung des Schalldruckpegels eines mit Hochspannung betriebenen Messobjektes (1), insbesondere eine Hochspannungsdrossel oder ein Hochspannungstransformator, wobei eine zum Messobjekt (1) relativ beweglich angeordnete Messeinrichtung (2), welche zumindest ein auf einem Träger (9) angeordnetes Mess-Mikrofon (8) aufweist, entlang eines Messpfades (3) in einem vorgebbaren Abstand (5) zum Messobjekt (1) bewegt wird,
mit folgenden Verfahrensschritten:,
- Bewegen eines mobilen, selbstnavigierenden Messroboters (4), auf welchem der Träger (9) befestigt ist, entlang des Messpfades (3),
- Erfassen von Messwerten des Schalldruckpegels mittels des zumindest einen Mess-Mikrofons (8),
- Übermitteln von Messwerten des Schalldruckpegels auf einem Übertragungskanal (6), der die Positionierung- und Steuereinheit (4) mit einer Steuer- und Auswerteinheit (7) verbindet.

## Beschreibung

### Technisches Gebiet

Die Erfindung betrifft ein Verfahren zur Messung des Schalldruckpegels eines mit einer Hochspannung betriebenen Messobjektes, insbesondere eine Hochspannungsdrossel oder ein Hochspannungstransformator, wobei eine zum Messobjekt relativ beweglich angeordnete Messeinrichtung, welche zumindest ein auf einem Träger angeordnetes Mess-Mikrofon aufweist, entlang eines Messpfades in einem vorgebbaren Abstand zum Messobjekt bewegt wird.

### Stand der Technik

Hochspannungsdrosselspulen und Hochspannungstransformatoren werden bei ihrer Herstellung einem umfassenden Prüfungs- und Inspektionsprogramm unterzogen. Die Messung von Betriebsgeräuschen ist dabei Teil der Routineprüfung. Da es sich um Anlagen handelt, die im Freien verwendet werden, ist der gemessene und garantierte Schallleistungspegel nachzuweisen. Dies erfolgt am Ende des Herstellungsprozesses in Form eines Prüfprotokolls, das der Lieferung üblicherweise beigefügt wird.

Die Vorgehensweise bei der Messung der Geräuschemission ist durch verschiedene Richtlinien, Vorschriften und Normen geregelt; für Hochspannungsdrosseln und Leistungstransformatoren ist IEC 60076-10 maßgeblich für die Bestimmung von Schalldruckpegel, Schallintensität und Schallleistung. Bei der praktischen Durchführung können zwei Messmethoden unterschieden werden:

Bei der so genannten "Punkt-Zu-Punkt-Methode" wird der Schalldruckpegel an vorgegebenen Punkten statisch gemessen. Dabei wird ein Mess-Mikrofon von einer die Messung durchführenden Person manuell in eine Mess-Position gebracht. Für die Messung an einer Hochspannungsdrossel oder einem Hochspannungstransformatoren sind oftmals mehr als 100 individuelle Messungen erforderlich. Die räumliche Mittelung der gemessenen Schalldruckpegel erfolgt manuell durch den Messtechniker.

Bei der so genannten "Walk-Around-Methode", wird das Messinstrument vom Messtechniker entlang eines Messpfades bewegt. Während dieser Bewegung werden die Messwerte des Schalldruckpegels erfasst. Die räumliche Mittelung der gemessenen Schalldruckpegel führt das Messgerät durch.

Beide Methoden haben den gravierenden Nachteil, dass die Positionierung des Mess-Mikrofons nicht exakt ist. Üblicherweise ist das Mess-Mikrofon an einer Isolierstange befestigt, die der Messtechniker in seinen Händen hält. Für ihn ist es kaum möglich, das Mess-Mikrofon in den vorgegebenen Raumpunkten mit der gewünschten Genauigkeit im Raum zu platzieren. Die Reproduzierbarkeit einer Messung ist daher nur eingeschränkt möglich.

Ein weiterer wesentlicher Nachteil ergibt sich daraus, dass die Messung in der Nähe von Maschinenteilen durchgeführt wird, die sich auf Hochspannungspotential befinden. Daraus ergibt sich für Personen ein erhebliches Gefährdungspotenzial. Manche Messpunkte scheiden aus Sicherheitsgründen aus.

Manuell durchgeführte Geräusch-Messmethoden erfordern einen erheblichen Zeitaufwand. Die Erstellung des Prüfprotokolls ist daher kostenintensiv.

### Darstellung der Erfindung

Es ist eine Aufgabe der vorliegenden Erfindung ein Verfahren zur Messung des Schalldruckpegels eines mit einer Hochspannung betriebenen Messobjektes, wie beispielsweise einer Hochspannungsdrossel oder eines Hochspannungstransformators anzugeben, das mit einem geringeren Fehler behaftet ist, und wobei das Gefährdungspotenzial für Personen bei der Durchführung der Messung weitgehend reduziert ist, und das einen geringeren Zeitaufwand erfordert.

Die Lösung der Aufgabe erfolgt durch die Merkmale des Anspruchs 1.

Vorteilhafte Ausgestaltungen, Aspekte und Einzelheiten der Erfindung ergeben sich aus den abhängigen Ansprüchen, der Beschreibung und der beigefügten Zeichnung.

Die Erfindung geht von Konzept eines selbstnavigierenden Roboters aus, der nach einer Initialisierungsphase eigenständig den Messvorgang im Gefahrenbereich der hochspannungführenden Maschinenteile durchführt.

Das erfindungsgemäße Verfahren weist folgende Verfahrensschritte auf:
- Bewegen eines selbstnavigierenden Messroboters, auf welchem ein Träger mit zumindest einem Mess-Mikrofon befestigt ist, entlang eines Messpfades;
- Erfassen von Messwerten des Schalldruckpegels mittels des zumindest einen Mess-Mikrofons;
- Übermitteln der Messwerte des Schalldruckpegels auf einem Übertragungskanal, der die Steuereinrichtung des Messroboters mit einer Steuer- und Auswerteeinheit verbindet.

Durch den Einsatz eines Messroboters, d.h. einer selbst bewegten, automatisch navigierenden, PositionierungsEinrichtung, kann man eine Mess-Mikrofon-Anordnung mit vergleichsweise besserer Genauigkeit in die gewünschte Messposition bringen. Dies hat den wesentlichen Vorteil, dass das Messergebnis genauer und die Messung reproduzierbar ist. Da ein manuelles Hantieren der Messeinrichtung in der Nähe von Hochspannung führenden Maschinenteilen nicht erforderlich ist, fällt auch das Gefährdungspotenzial für die handelnden Personen weg. Es können Messpunkte gemessen werden, die bei manueller Platzierung des Mess-Mikrofon aufgrund des Gefährdungspotenzials unzugänglich waren. Da nach einer Initialisierungsphase, in welcher die Positionierung- und Steuereinheit programmiert wird, - der eigentliche MessVorgang automatisch abläuft, lässt sich die Messung der Geräuschimmission vergleichsweise rasch und mit weniger Aufwand bewerkstelligen.

Um den technischen Aufwand für die mobile Positionierung- und Steuereinheit möglichst einfach zu gestalten kann es von Vorteil sein, wenn die erfassten Geräusch-Messwerte von einer stationären Steuer- und Auswerteeinheit ausgewertet werden und an diese leitungslos übermittelt werden. Dies kann beispielsweise durch Funksignale erfolgen, bevorzugt beispielsweise durch eine WLAN Verbindung zwischen der mobilen Positionierung- und Steuereinrichtung und der in einem örtlichen Abstand zum Messobjekt stationär angeordneten Steuer- und Auswerteeinheit. Das Bedienpersonal kann dabei in sicherem Abstand zum Gefahrenbereich agieren.

Mit Vorteil kann dabei die so genannte "Punkt-Zu-Punkt-Methode" dadurch realisiert werden, indem die selbstnavigierende Positionierung- und Steuereinheit an vorgebbaren Mess-Positionen des Messpfades stoppt, und in jeder dieser Mess-Positionen zumindest einen Messwert des Schalldruckpegels erfasst und diesen zumindest einen Messwert an die Steuer- und Auswerteeinheit übermittelt. Sobald die Messung in einer Mess-Position abgeschlossen ist, wird automatisch die nächste Position angefahren. Die Positionierung des Mess-Mikrofons durch den Messeroboter kann im Vergleich zur manuellen Positionierung genauer durchgeführt werden. Personen werden bei der Messung nicht gefährdet.

Mit Vorteil kann dabei die so genannten "Walk-Around-Methode" dadurch realisiert werden, indem die selbstnavigierende Positionierung- und Steuereinheit mit einer kontinuierlichen Geschwindigkeit entlang des Messpfades bewegt wird und dabei fortwährend an vorgebbaren Mess-Positionen Messwerte des Schalldruckpegels an die Steuer- und Auswerteeinheit übermittelt. Die Geschwindigkeit mit der ein Mess-Mikrofon entlang des Messpfades bewegt wird lässt sich dadurch vergleichsweise genau einhalten, so dass gewonnene Messwerte reproduzierbar sind. Auch hier kann die Messung in sicherem Abstand und ohne Gefahr für eine Person durchgeführt werden.

Wenn Umrechnungsverfahren und Mittelungsverfahren der einzelnen Messwerte nicht manuell, sondern computergestützt durchgeführt werden, erfordert die Erstellung eines Prüfprotokolls einen geringeren Aufwand. Mit Vorteil erfolgt die Berechnung des "average sound intensity level", bzw. die räumliche Mittelung und andere rechenintensive Verfahren in der örtlich entfernt angeordneten Steuer-und Auswerteeinheit.

Es kann günstig sein, wenn die selbstnavigierende Positionierung- und Steuereinheit bordseitig mit einer eigenen optisch oder funktechnisch arbeitenden Positionsbestimmungseinrichtung ausgestattet ist. Dadurch kann der Messroboter sich an die jeweilige Kontur eines Messobjektes selbstständig anpassen.

Hierbei kann es vorteilhaft sein, wenn für den Messeroboter kommerziell verfügbare Laserscanner oder GPS-Systeme zum Einsatz kommen.

Für kraftangetriebene Fortbewegung des Messroboters eignen sich verschieden Antriebsarten von bodenhaftenden Rädern. Mit Vorteil ist der Antrieb ein elektrischer Antrieb. Günstig kann ein omnidirektionaler Antrieb sein, mit dem ein Trägerfahrzeug samt Messeinrichtung jederzeit in eine beliebige Richtung bewegt werden kann.

### Kurzbeschreibung der Zeichnung

Zur weiteren Erläuterung der Erfindung wird im nachfolgenden Teil der Beschreibung auf Zeichnungen Bezug genommen, aus denen weitere vorteilhafte Ausgestaltungen, Einzelheiten und Weiterbildungen der Erfindung anhand eines nicht einschränkenden Ausführungsbeispiels zu entnehmen sind. Es zeigen:

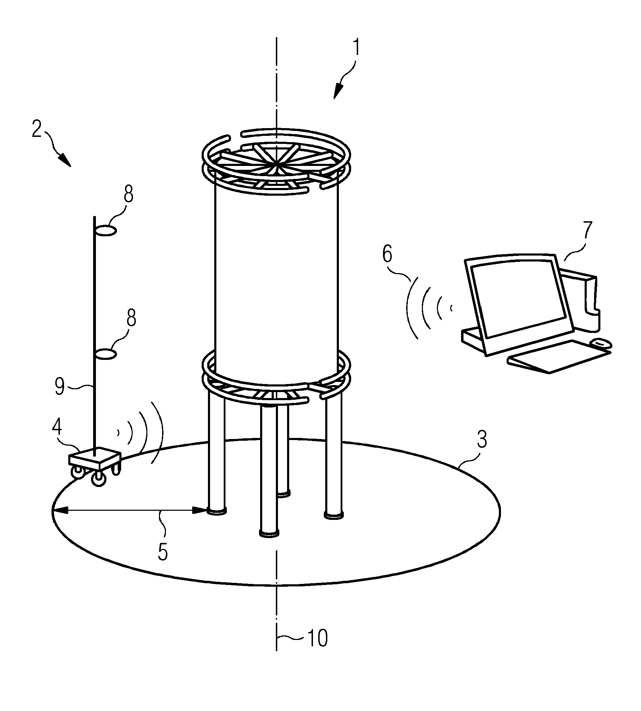

- Figur 1: eine schematische Ansicht eines Messaufbaus für die Messung des Schalldruckpegels einer Hochspannungsdrosselspule wobei gemäß der Erfindung eine selbstnavigierende Positionierung- und Steuereinheit (Messroboter), auf welcher eine Isolierstange mit zwei Mess-Mikrofonen befestigt ist, entlang eines Messpfades bewegt wird, wobei Messwerte der Schalldruckpegels gemessen werden, und wobei diese Messwerte über einen Übertragungskanal, an eine entfernte Steuer- und Auswerteeinheit übermittelt werden.

### Ausführung der Erfindung

Die Figur 1 zeigt in einer schematischen Darstellung beispielhaft einen robotergestützten Messaufbau zum Messen des Schalldruckpegels einer Hochspannungsdrossel. Anhand dieses Beispiels wird das erfindungsgemäße Verfahren im Folgenden näher erläutert.

Wie in Figur 1 gezeichnet, ist die Hochspannungsdrosselspule 1 über vier Isolatoren in einem Prüflabor am Boden befestigt. Die Hochleistungsdrosselspule 1 hat die Form eines Zylinders. Zum Zweck der Geräuschmessung fährt um die Zylinderachse 10 eine mobile Messeinrichtung 2. Die Bewegung erfolgt mit einer Positionierung- und Steuereinheit 4, einem Messroboter 4. Wie unten stehend näher erläutert, ist der Messpfad 3 durch Programmierung des Roboters 4 vorgebbar. Im Beispiel der Figur 1 ist der Messpfad 3 eine Kreisbahn. Der Mess-Abstand zur schallabstrahlenden Mantelfläche des Messobjektes 1 ist in IEC 60076-10 festgelegt, z.B. 0,3 m, 1 m bzw. 2 m. Die Kreisbahn 3 ist konzentrisch zur Zylinderachse 10. Die Hochleistungsdrosselspule 1 hat eine Zylinder-Höhe von 9 m. Die Geräusch-Messung erfolgt in verschiedenen Höhenabschnitten der Zylinderspule. Die einzelnen Messpunkte einer Messebene sind gleich beabstandet. Die Lage der Messpunkte ist in Form eines Messrasters z.B. durch IEC 60076-10 vorgegeben.

Der Messroboter 4 weist eine mobile Positionierungseinheit auf, das ist im vorliegenden Fall ein elektronisch gesteuertes Trägerfahrzeug. Die Traktion des Trägerfahrzeugs 4 erfolgt über Räder. An der Oberseite des Trägerfahrzeugs 4 ist ein Träger 9 für Mess-Mikrofone befestigt. Der Träger 9 ist aus einem Isolierstoff gefertigt. Im vorliegenden Beispiel ist der Träger 9 eine vertikal angeordnete Isolierstange 9. Auf der Isolierstange 9 sind zwei in einem Abstand zueinander angeordnete Mess-Mikrofone 8 montiert. Der Messroboter 4 ist bordseitig mit einem Steuerrechner (Mikrocontroller) ausgestattet, auf dem jeweils ein Programm zur Steuerung der Antriebsräder bzw. zur Steuerung eines Kommunikations-Ablaufs zur Datenübertragung ablauffähig ist. Der Messroboter 4 navigiert am Fußboden des Prüfraums vollautomatisch zu vorbestimmten Messpositionen und führt die Schallemissionsmessung eigenständig durch. Ferner erfolgt auf der mobilen Einheit 4 eine Messsignal-Vorverarbeitung, so dass diese Messsignal zu einer örtlich entfernten Steuer- und Auswerteeinheit 7 übertragen werden können. Diese Signalübertragung zu einem externen Gerät erfolgt auf dem Übertragungskanal 6. Der Übertragungskanal 6 ist zumindest in einem Abschnitt als Funkkanal ausgebildet. Im vorliegenden Beispiel ist dieser Funkkanal eine WLAN-Kommunikationsverbindung.

Die Steuer- und Auswerteeinheit 7 ist im dargestellten Beispiel ein Master-Kontroll-Rechner, der an einem entfernten Ort in einer Warte angeordnet ist; anstelle dieses stationären Master-Kontroll-Rechners könnte aber natürlich auch ein handelsüblicher Laptop eingesetzt werden.

Der selbstnavigierende Messroboter 4 verfügt zudem über eine Positionsbestimmungseinrichtung zur Bestimmung der Ortsinformation. Diese erlaubt der mobilen Einheit 4 während einer automatisch ablaufenden Geräusch-Messung an definierten Punkten des Messpfades 3 zu stoppen ("Punkt-Zu-Punkt-Messverfahren"), bzw. eine durch den Messpfad 3 vorgegebene Route mit vorgebbarer Geschwindigkeit zu befahren ("Walk-Around-Messverfahren"). Dabei wird in beiden Fällen ein definierter Abstand 5 zum Messobjekt 1 eingehalten. Der Abstand 5 ist so bemessen, dass das Schall-Fernfeld des Objektes 1 erfasst wird.

Im vorliegenden Beispiel ist die PositionsbestimmungsEinrichtung ein Laserscanner (in der Zeichnung nicht näher dargestellt), der die Silhouette des Messobjektes 1 während seiner Fahrt auf dem Messpfad 3 mittels eines Laserstrahls fortwährend abtastet und durch Empfang des reflektierten Signals und dessen Auswertung einen Soll-Istwert-Vergleich durchführt. Dadurch wird erreicht, dass innerhalb vorgebbarer Grenzen der vorbestimmte Abstand 5 zum Messobjekt 1 stets eingehalten wird. Im vorliegenden Ausführungsbeispiel ist die Abweichung zwischen Soll- und Ist-Position besser als +/- 1 cm. Eine wesentliche Verbesserung, wenn man bedenkt, dass bei der manuellen Positionierung einer Mess-Mikrofon-Anordnung reproduzierbar eine Genauigkeit von 20 cm kaum erreicht werden kann.

Die Positionsbestimmungseinrichtung kann aber auch über Funksignale, zum Beispiel über ein so genanntes "Indoor-GPS" erfolgen.

Für die Erstellung eines Prüfprotokolls wird die Hochleistungsdrosselspule 1 in einem Prüflabor über Isolatoren am Boden fest verankert und in simulierten Betriebsbedingungen an ein Hochspannungsnetz angeschlossen. Das Prüffeld ist ein schallgedämmter Raum, so dass störender Fremdschall weitgehend ausgeschlossen werden kann. Der Messroboter 4 fährt am Fußboden des Prüfraums. Er befindet sich zu Beginn einer Messung in einer Starposition des Prüfraums. Zu Beginn einer Messung initialisiert die Steuer-und Auswerteeinheit 7 den Messroboter 4. Während dieser Initialisierungsphase werden Daten an die Steuereinheit des Roboters 4 übertragen, darunter: Informationen über die Methode der Geräuschmessung ("Punkt-Zu-Punkt" oder "Walk-Around"), den Messpfad 3 und den Abstand 5, sowie Anzahl und räumliche Lage der Messpunkte bzw. der Geschwindigkeit, sowie Anordnung der Mess-Mikrofone 8. Nach dieser Initialisierungsphase folgt der Start. Daraufhin begibt sich der Messroboter 4 aus eigenem Antrieb auf den vorgeschriebenen Messpfad 3. Sobald er diesen Messpfad 3 erreicht hat, beginnt die eigentliche Messung, indem das Trägerfahrzeug 4 die Isolierstange 9 mit den darauf befindlichen Mess-Mikrofonen 8 auf dem Messpfad 3 bewegt und damit in der Nähe der mit Hochspannung betriebenen Drosselspule 1 das Geräusch-Messprogramm absolviert. Der Messroboter 4 navigiert dabei am Fußboden des Prüflabors vollautomatisch. Die Mikrofon-Messpunkte werden entweder Schritt für Schritt ("Punkt-Zu-Punkt-Methode") angefahren, oder mit vorgegebener kontinuierlicher Geschwindigkeit ("Walk-Around-Methode") auf der vorgegebene Route des Messpfades 3 bewegt. Das von der Zylinder-Mantelfläche des Messobjektes 1 abgestrahlte Schallfeld wird unter realen Betriebsbedingungen über einen repräsentativen Betriebszeitraum gemessen. Während dieses Messintervalls werden Messwerte über die WLAN-Verbindung 6 an die Steuer-und Auswerteeinheit 7 übertragen. Die Mittelwertbildung und gegebenenfalls eine weitere rechentechnische Aufbereitung gemäß Parametern der IEC 60076-10 erfolgt in der Steuer- und Auswerteeinheit 7. Abschließend werden die rechentechnisch aufbereiteten Messwerte in das Prüfprotokoll der Hochspannungsdrosselspule 1 übertragen.

Am Ende des Messvorgangs verlässt der Messroboter 4 eigenständig wieder den Gefahrenbereich der Hochspannung und begibt sich an den definierten Ausgangsort. Dort steht er dann für eine neue Initialisierung bzw. Messung zur Verfügung.

Es versteht sich, dass in analoger Form auch die Geräuschemissionen an einem Leistungstransformator messtechnisch ermittelt werden kann. In diesem Fall ist i. d. R. der Bezugskörper nicht ein Bezugs-Zylinder, sondern ein Bezugs-Quader; dementsprechend ist die Begrenzungsfläche bzw. das Messgitter bei der Geräuschmessung, d.h. der Messpfad 3 für den Messroboter 4 ist dann nicht ein Kreis, sondern ein Polygon, entsprechend der Grundriss-Kontur des Leistungstransformators. IEC 60076-10 findet analoge Anwendung.

Im Ergebnis lässt sich abschließend festhalten, dass durch die vollautomatische Messung mit einem selbstnavigierenden Messroboter die Messung der Geräuschimmission mit vergleichsweise höherer Präzision und Reproduzierbarkeit durchgeführt werden kann. Dank der robotergeführten Messeinrichtung besteht keine Gefährdung für Personen, die die Messung durchführen. Im gefährlichen Hochspannungsbereich ist keine Arbeit mehr erforderlich. Die Zeitersparnis ist ein Kostenvorteil bei der Erstellung des Prüfprotokolls.

Obwohl die Erfindung im Detail durch das bevorzugte Ausführungsbeispiel näher illustriert und beschrieben wurde, so ist die Erfindung nicht durch das offenbarte Beispiel eingeschränkt und andere Variationen können von Fachmann hieraus abgeleitet werden, ohne den Schutzumfang der Erfindung zu verlassen. So kann der Messroboter auch anders ausgeführt sein, beispielsweise auf einem Plateau einer Trägerplatte sich bewegen. Die Kraftangetriebene Fortbewegung des Trägerfahrzeugs kann auch über Ketten erfolgen. Selbstverständlich können zur Bestimmung der Ortsinformation auch andere bekannte Verfahren zur Positionsbestimmung in Gebäuden verwendet werden, wie zum Beispiel optische, Z.B. Infrarot. Die Messfläche variiert je nach Raumform des Messobjektes. Auf dem Sensor-Träger können ein, zwei oder auch mehrere Mess-Mikrofone angeordnet sein. Entsprechend werden eben mehrere Mess-Ebenen gleichzeitig erfasst. Selbstverständlich kann auch jeder außerhalb einer Norm liegender Messpunkt durch das erfindungsgemäße Geräuschmessverfahren erfasst und im Rahmen eines Prüfprotokolls dokumentiert werden.

### Zusammenstellung der verwendeten Bezugszeichen

- 1: Messobjekt, Hochspannungsdrossel
- 2: Messeinrichtung
- 3: Messpfad
- 4: Messroboter
- 5: Abstand
- 6: Übertragungskanal
- 7: Steuer- und Auswerteeinheit
- 8: Mess-Mikrofon
- 9: Träger, Isolierstange
- 10: Zylinderachse

## Patentansprüche

1. Verfahren zur Messung des Schalldruckpegels eines mit Hochspannung betriebenen Messobjektes (1), insbesondere eine Hochspannungsdrossel oder ein Hochspannungstransformator, wobei eine zum Messobjekt (1) relativ beweglich angeordnete Messeinrichtung (2), welche zumindest ein auf einem Träger (9) angeordnetes Mess-Mikrofon (8) aufweist, entlang eines Messpfades (3) in einem vorgebbaren Abstand (5) zum Messobjekt (1) bewegt wird,
mit folgenden Verfahrensschritten:,
- Bewegen eines mobilen, selbstnavigierenden Messroboters (4), auf welchem der Trtäger (9) befestigt ist, entlang des Messpfades (3),
- Erfassen von Messwerten des Schalldruckpegels mittels des zumindest einen Mess-Mikrofons (8),
- Übermitteln von Messwerten des Schalldruckpegels auf einem Übertragungskanal (6), der die Positionierung- und Steuereinheit (4) mit einer Steuer- und Auswerteinheit (7) verbindet.

2. Verfahren nach Anspruch 1, **dadurch gekennzeichnet, dass** die Messwerte auf dem Übertragungskanal (6) zumindest abschnittsweise als Funksignale übermittelt werden.

3. Verfahren nach Anspruch 1 oder 2, **dadurch gekennzeichnet, dass** der selbstnavigierende Messroboter (4) an vorgebbaren Mess-Positionen des Messpfades (3) stoppt, und in jeder dieser Mess-Positionen zumindest einen Messwert des Schalldruckpegels erfasst und diesen zumindest einen Messwert an die Steuer- und Auswerteeinheit (7) übermittelt.

4. Verfahren nach Anspruch 1 oder 2, **dadurch gekennzeichnet, dass** der selbstnavigierende Messroboter (4) mit einer kontinuierlichen Geschwindigkeit entlang des Messpfades (3) bewegt wird und dabei fortwährend an vorgebbaren Mess-Positionen Messwerte des Schalldruckpegels an die Steuer- und Auswerteeinheit (7) übermittelt.

5. Verfahren nach Anspruch 3 oder 4, **dadurch gekennzeichnet, dass** mittels der Steuer- und Auswerteeinheit (7) eine räumliche Mittelung der Messwerte des Schalldruckpegels durchgeführt wird.

6. Verfahren nach Anspruch 3, 4 oder 5, **dadurch gekennzeichnet, dass** der selbstnavigierende Messroboter (4) bordseitig eine optische oder funktechnische Positionsbestimmungseinrichtung mit sich führt.

7. Verfahren nach Anspruch 6, **dadurch gekennzeichnet, dass** die Positionsbestimmungseinrichtung zum Zwecke der Bestimmung der momentanen Ortsinformation einen Laserscanner oder ein GPS-System verwendet.

8. Verfahren nach einem der Ansprüche 1-7, **dadurch gekennzeichnet, dass** die Steuer- und Auswerteeinrichtung (7) während einer Initialisierungsphase an die selbstnavigierende Positionierung- und Steuereinheit (4) Daten übermittelt, enthaltend Informationen betreffend die Mess-Methode ("Punkt-Zu-Punkt" oder "Walk-Around"), Sollwerte des Messpfad (3), Information über den Abstand (5), sowie Anzahl und räumliche Lage der Messpunkte bzw. der Geschwindigkeit, sowie räumliche Anordnung der Mess-Mikrofone (8) auf der Isolierstange (9).

9. Verfahren nach Anspruch 8, **dadurch gekennzeichnet, dass** die selbstnavigierende Positionierung- und Steuereinheit (4) so eingerichtet ist, dass bei der Bewegung die örtliche Abweichung von vorgegebenen Sollwerten des Messpfades kleiner als 2 cm ist.

10. Verfahren nach Anspruch 9, **dadurch gekennzeichnet, dass** das Messobjekt (1) eine zylinderförmige Hochspannungsdrossel ist, die mittels Isolatoren auf einem Untergrund oder einer Montageebene montiert ist, und wobei der Messpfad (3) ein um die Zylinderachse (10) konzentrischer Kreis ist.

11. Verfahren nach Anspruch 10, **dadurch gekennzeichnet, dass** für den selbstnavigierenden Messroboter (4) ein mit Antriebsrädern versehenes Trägerfahrzeug verwendet wird.

12. Verfahren nach Anspruch 11, **dadurch gekennzeichnet, dass** für die Antriebsräder ein omnidirektionaler Antrieb verwendet wird.
